# EUROPEAN PATENT APPLICATION

(11) **EP 1 487 019 A1**
(43) Date of publication of application: **15.12.2004**
(21) Application number: 03101729.6
(22) Date of filing: 12.06.2003
(51) Int. Cl.: H01L 23/538

(54) **Electronic device and method of manufacturing thereof**

(71) Applicant: Koninklijke Philips Electronics N.V., 5621 BA Eindhoven (NL)
(72) Inventor: The designation of the inventor has not yet been filed
(74) Representative: Slenders, Petrus Johannes Waltherus

(57) **Abstract**

The electronic device comprises a substrate (1) with a cavity (6) in which an active device (8) is present. At the first side (2) of the substrate (1) an interconnect structure (17) extends over the cavity (6) and the substrate (1). At the second side (3) of the substrate (1), to which the cavity (6) extends a heat sink (23) is available. The device is particularly suitable for use at high frequencies, for instance higher than 2 GHz and under conditions of high dissipation.

## Description

The invention relates to an electronic device comprising:
- a substrate having a first and a second opposed side, which is provided with a first cavity having an aperture at the first side of the substrate, the substrate being provided with a first electrical element at its first side;
- an active device having a coupling surface provided with connection pads, which device is present in the first cavity of the substrate with its coupling surface at the first side of the substrate, and
- electrical connections to interconnect the active device with the electrical element.
The invention further relates to methods of manufacturing thereof.

Such an electronic device is known from US-A 4,739,389. The known device comprises a semiconductor substrate with passive parts of the circuit. The active device is a semiconductor device having a body of another semiconductor material than the semiconductor substrate. The electrical connection between the active and the passive elements are realized by wirebonding. It is particularly suitable for use at high frequencies in that the semiconductor body of the active device is provided with a low-ohmic semiconductor zone which extends at least locally as far as the - bottom - surface opposed to the coupling surface and is connected in an electrically conducting manner to a conductive pattern for the reference potential - which is generally a ground plane.

It is a disadvantage of the known device, that the high frequency behavior - at frequencies above 2 GHz, and particularly at frequencies above 10 GHz - is not yet good enough. The known device shows signal distortion and attenuation.

It is therefore an object of the invention to provide an electronic device of the kind mentioned in the opening paragraph, in which the signal distortion is substantially decreased or to a large extent absent.

This object is achieved in that the cavity extends to the second side of the substrate, that any space left in the cavity is filled with a filling material, that a thin film interconnect structure is provided at the first side of the substrate extending over the first cavity and interconnecting the semiconductor device with the electrical element, the interconnect structure comprising connection faces corresponding to the connection pads, and that a heat sink is provided at the second side of the substrate extending over the first cavity and at least part of the substrate.

It was found that several dies can be provided with one common interconnect structure, if any spaces between the active device and the substrate are filled with a filler material. Due to the common interconnect structure, there is no need to use bonding wires, which are in practice at high frequencies an obstacle leading to attenuation and signal distortion. The size of the connection pads and connection faces may vary from that of vertical interconnect areas to bond pad sizes suitable for the use of metal or solder balls. Preferably the size is smaller than 50*50 µm, more preferably less than 20*20 µm. The heat sink in the present invention functions as mechanical support at the same time. This allows a reduction of the substrate thickness, leading to better heat dissipation, and a shorter path to the ground plane, if - as preferred - the heat sink functions as ground plane at the same time. The lateral interconnect in the structure extending over a substantial length in the order of micrometers, are provided with a transmission line character.

The disadvantages of bond wires resides in the following. First of all, bond pads of considerable size are needed for the assembly of bond wires. The disadvantage thereof is the resulting parasitic capacity to ground. Secondly, the bond wires act as inductors, leading to an increasing impedance mismatch with increasing frequency *jωL,* with ω the frequency, *L* the inductance and *j* the symbol for the imaginary component of the impedance. The impedance of a direct and thus shorter connection is smaller. Besides, such impedance can be better predicted. Furthermore, the interconnects in the present invention are structures on a continuous substrate. In the known device a gap between the active device and any passive parts of the circuit is bridged by the bond wires. The parasitic impedance between the wires and the substrate in the area of the gap is different from that elsewhere. In the device of the invention however, the gaps are filled with any suitable material. Ideally, the capacitance density of the substrates is equal for all areas. The continuity thus enables the provision of integrated, well-defined designed transmission lines, such that artifacts as reflections, spurious modes and undesired interaction with the semiconductor devices can be prevented. Moreover, such bond wires must be provided one after the other, whereas an interconnect structure can be provided on wafer level.

It is an advantage of the present invention, that it can be used for wide-band applications. A conventional solution to get rid of any parasitic inductance is the addition of a capacitor, of which the impedance is the complex inverse, such that at least the imaginary part of the impedance is leveled out. However, this leveling out only occurs for specific frequencies. In the current approach, the complete impedance is kept low, such that such leveling out is not necessary.

It is another advantage that heat can be dissipated efficiently. This is advantageous both at high frequencies but also at lower frequencies. This is very clear if the active device is a power amplifier. Besides, integrated circuits and modules therewith tend to have a reduced space but increased functionality. This combination leads to an increased heat production per surface area, for which the heat sink of the present embodiment provides a solution. The presence of the heatsink over both the active device and at least part of the substrate assures, that the device has at every place the same temperature. If so desired, there is thus no need to provide corrections in the design to accomodate differences in temperature. The heatsink will in general act as a mechanical support as well. It may be structured in a desired pattern, which for instances keeps the separation lanes free.

The invention has furthermore as advantage, that any interconnect structure that is part of the active device and/or related to the electrical element may be embodied in a minimal manner. This is particularly the case with the active device. In the prior art, there were only a number of external contacts available in view of the necessary space of the bond wires. In the invention, the electrical connection between the active device and the interconnect structure may be provided with any suitable means including standard IC interconnect technology (i.e. growing metal layers of Al, AlCu or Cu for instance), and standard assembly interconnect technology, such as the use of metal or solder bumps or anisotropically conducting glue. It is in that respect very advantageous, that the connection pads at the coupling surface of the active device are not only present near the edges of the surface, but provided over the complete surface. Such provision of connection pads over the complete surface can be realized in that the connection pads are provided on top of a passivation layer. Since the invention requires only small connection area, the active devices are generally not bond pad limited anymore and it is cost effective to combine various technologies.

The interconnect structure in the device of the invention can both be a single-layered or a multilayer interconnect structure. This will depend on the actual functional density in the substrate and the number of elements to be provided onto the substrate, as part of the interconnect structure. Such elements include desired passive structures, such as resistors, capacitors and inductors. The capacitors can be provided with any desired dielectric, and the inductors can be provided in a desired design and in layers of sufficient thickness so as to ensure a sufficiently high Q factor. Further examples of elements include micro-electromechanical system (MEMS) switches and capacitors, resonators, couplers, antennas, baluns, band pass filters, matching circuits and the like. The interconnect structure may include bond pads for external contacting with solder balls, or a flex foil technology.

In a preferred embodiment, the interconnect structure comprises a first transmission line extending over the first cavity and the substrate. Such transmission line is enabled due to the planar first side of the substrate. Its presence is furthermore suitable for high-frequencies, so as to have excellent transmission of signals. The transmission line may be of any type known including a microstrip, a stripline, a coplanar waveguide and a coupled transmission line of the same type to carry differential signals. Since the interconnect structure extends over both the substrate and the active device(s), there is sufficient space for providing any ground plane needed. Coplanar waveguides are preferable in view of the achievable pattern density. Particularly preferable is a combination of a coplanar waveguide and a microstrip. This is a structure having one or two signal lines between two ground lines in one plane, and a ground in a neighboring plane. In this manner, the signal line is optimally shielded from external influences.

In order to provide a stripline, having a signal line in between of two ground planes, the interconnect structure may be a multilayered structure. These planes preferably extend only locally, e.g. are patterned, and the various plane are all connected to one or more connections to ground. If the interconnect structure is multilayered, it is preferable that the conducting layers are signal layers and ground layers alternatingly. Coupling between signal layers may be realized with vertical interconnects, but also with holes in the ground planes.

The ground planes needed are preferably connected to the heat sink, which in that case also functions as ground plane. The importance of a low impedance ground plane increases with the frequency. The heat sink of the invention is suited very well for that purpose. This coupling of ground planes to ground is preferably as short as possible. Reasons behind this are that the distance between the ground and the signal lines determines the resolution of the signal lines, and that the ground ideally has an equal impedance at all places, hence short connections are needed.

The connection of ground to heat sink can be advantageously realized with vertical interconnects extending from the interconnect structure to the heat sink This direct path can be shortened further in that the substrates are thinned as far as possible. Such thinning is possible in the device of the invention, as the heat sink, and not the substrate, assures the mechanical stability of the device.

The filler material used to fill the cavity is preferably a material having a dielectric constant that is comparable to that of the semiconductor substrate. This has the advantage that the distributed capacitance between the signal line and ground is uniform along the length of the transmission line. In this respect the distance between the active device and the side walls of the substrate is preferably as small as possible. Generally, such filler materials are provided with a wet-chemical process, such as spincoating, spraying, web coating or the like. Suitable materials are for instance bencocyclobutenes and polyimides, as they provide very good adhesion properties. However, the filling material can be a metal as well, as far as the space between substrate and active device can be reached in a plating bath.

The presence of a heat sink is particularly advantageous for applications at high frequencies. As the switching time decreases with increasing frequency, the number of actions taking place per second is very large at high frequencies. As a consequence, much power is used that must be dissipated in order to assure the proper functioning of the devices. The heatsink will be coupled to a thermally conducting material of a carrier - leadframe or board or external heat sink with large surface area. This allows sufficient heat dissipation to ensure proper operation of the device.

An additional effect is that active devices conventionally used at these frequencies comprise a semiconductor substrate of a compound material. Such compound material is a bad heat conductor. Due to the provision of a heat sink over the first cavity and at least part of the substrate, there is a large surface for heat dissipation. Any temperature differences locally present at the second side of the substrate can be leveled out fast. Furthermore, there are in fact two parallel paths from the active device to the heat sink: either directly or through the substrate. Since the lateral dimensions of the active devices will generally be considerably larger than the vertical dimension, the first path is dominant.

Another advantage of this heatsink is that an there are various possibilities for the assembly. In a first suitable embodiment no leadframe is necessary. Parts of the layer acting as heatsink, but electrically insulated thereof, function as bondpads. Such bondpads are suitable connected to the interconnect structure with vertical interconnects. In such a manner the actual layout of bondpads and heatsink can be equal to that of standard leadframes such as the HVQFN-type.

In a second embodiment, there are bond pads in the interconnect structure, and there is a leadframe. The heatsink is attached to a conductive plane in the leadframe, and the bond pads are connected to the leadframe with wirebonding. The advantage of the heatsink at the substrate is that its allows rerouting of the heatsink: the active device need not to be present in the center of the substrate, so that its backside can be attached to the conductive plane in the leadframe.

In a further embodiment, the heatsink allows to attach means for active heat removal, such as heat pipes. Also, in view of the fact that it can be grown in between of a removable photoresist structure, the effective surface of the heatsink may be increased very much by removal or partial removal of the photoresist.

The active device is preferably a semiconductor device used for processing. However, it may be as well any other functional device, such as a micro-electromechanical system (MEMS) element, or a filter, such as a surface or bulk acoustic wave filter, a balun, an antenna, a laser.

In order to provide a short path from the active device to the heat sink, it is preferred that the substrate of the active device is thinned. Thinning can be achieved with conventional techniques such as grinding and/or etching. According to a particularly preferred embodiment of the present invention the substrate is thinned to a thickness of less than 100 micrometer, preferably less than 50 micrometer, more preferably less than 20 micrometer, even more preferably less than 20 micrometer, most preferably less than 10 micrometer.

The substrate in the present invention is a semiconductor substrate by preference. This has as first advantage, that the device as a whole can be processed easily in conventional semiconductor fabs. It has furthermore the advantage that the properties of the substrate, and particularly silicon, can be tuned as desired, over the whole substrate or locally. For passive elements, it is very advantageous to use a high-ohmic silicon, preferably greater than 500 ohm.cm, such as high resistivity float zone silicon, high resistivity polycrystalline silicon, etc. One preferred embodiment is that a monocrystalline silicon substrate is provided with a surface layer of an high-resistivity layer, such as amorphous silicon, on top of which an oxide layer is present.

For active elements the semiconductor material such as Si or SiGe may be doped in zones as required to provide junctions. The substrate preferably comprises material having a pre-specified resistivity depending a.o. on the active semiconductor to be obtained, the resistivity usually ranging from 20 ohm.cm for bipolar semiconductors to 20 mohm.cm for CMOS semiconductors. Usually a thermal oxide layer (e.g. 1 µm thick) is provided on the first side of the substrate to prevent short-circuiting.

The presence of semiconductor devices in the substrate has the additional advantage that it allows an optimal choice of materials, while still only a single interconnect structure is needed. For instance, the device of the present invention may be used to convert a signal coming from an optical fiber into an electrical signal that is amplified according to the need. Therefore use is made of a photodiode, one or more amplifiers, various circuits. The photodiode may be provided on a semiconductor substrate of InP, the amplifiers may be implemented on a substrate of GaAs and the filters can be implemented on a silicon substrate. If desired, a transmitter IC based on SiGe may be provided as well.

It is preferred, that both a dipolar antenna and matching functions are provided in the device of the invention. In that case, it is possible that the signals are processed as differential signals, and that no conversion is done from differential to single ended format. Herewith, a balun is not needed. For such a transmission of differential signals double lines are needed, both from and to the antenna. However, as the parasitic inductance is considerably reduced, this is not problematic. A suitable antenna for this object is a stepped impedance dipole. This stepped impedance dipole comprises for instance two lines leading to two dipole bars, the difference in line width between the connection lines and the dipole bars forming the step of the stepped impedance dipole. Such antenna is small compared to the wavelength and symmetric with respect to ground. The matching circuit can be embodied as a parallel resonant impedance matching circuit, in which a first and a second transmission line are located substantially parallel to each other and mutually coupled by connection lines on one side and a capacitor on the other side. This capacitor is preferably embodied as a thin-film capacitor.

It is very much preferred that the device is provided with multiplexers and demultiplexers enabling a transformation between a low frequency input signal and a high frequency signal of desired frequency that is used for the signal transmission in the device. This implies that there are all input signals are low-frequency signals. The input signals are those signals provided from other units than the device within an audio/video transmission apparatus such as a video player, a computer, a mobile phone. The term 'low frequency' is herein understood to be a signal that can be transmitted with bond wires, flex foil connections or whatever conventional coupling means. The only other supply to the device is then the voltage supply.

The advantage hereof is that the device will include all relevant high-frequency functions. It can then be used as a plug-and-play module. Moreover, the high-frequency part can be designed as a whole, without having any undesired and uncontrollable distortion of the high-frequency behavior. The integration of all high-frequency functions into the device implies the integration of antenna, matching circuits, and band-pass filters, band switches so as to separate incoming and outgoing signals and/or signals of different frequency bands, power amplifiers and low noise amplifiers for the specific frequency bands, transmitter and receiver integrated circuits, voltage controlled oscillators, power control and multiplexers and demultiplexers for conversion between low and high frequencies.

It will be understood that it is highly preferable that all these elements are either provided as part of the interconnect structure, or are provided as active elements defined in the substrate or are active devices provided in cavities in the substrate. It is herewith not necessary, that each active device is present in a separate cavity. For reasons of efficiency, such as different amplifier stages to be coupled to each other directly, may be provided in a single cavity.

The device of the invention can be suitably used for hand held apparatus, in which a plurality of frequency bands need to be processed individually. Examples of the frequency bands include GSM, Bluetooth, Wireless LAN, 802.11, UMTS and LDMS. The device may further be used for specific high-frequency applications, such as needed for anticollision radars, which are intended for use in vehicles, and cars in particular.

It is preferable that the device of the invention comprises the signal transmission means for at least two frequency bands.

The device of the invention is further suitable for use in domestic and professional applications in which an optical signal need to be converted into an electrical signal. Such applications are foreseen in respect of the use of optical fibers for communication. A photo-diode - and in case the communication is bi-directional - a laser diode will replace therein the antenna(s) used in case of wireless communication. A system to realize such is known from EP-A 733288. This is a system with independent photodiode and laser diode that are placed in-line. However lateral pin-diodes are very suitable as well for use as photodiodes. The device of the invention can be used therewith with advantage in view of the good broadband properties of the transmission lines in the interconnect structure.

The device of the invention is furthermore very suitable to comprise both optical coupling means and wireless coupling means. The optical coupling can then be used as a broadband connection to an external fiber network, and the wireless coupling can be used for communication to internal different functions, such as for instance amplifiers and loudspeakers, or light switches. Applications hereof are advanced television and also video telephones. Alternatively, the device is included in a hand-held apparatus, such as a mobile phone, or a portable computer. The wireless communication is then the main communication medium, but the optical communication can be used in addition thereto, for instance in that a fiber is temporally attached to the apparatus.

In a suitable application the device of the invention comprises an active device with a substrate of a III-V material, such as InP, in which several semiconductor elements are defined. These semiconductor elements act as mixers, the design of which is known to the skilled person in the art. A substrate of insulating material or of high-ohmic silicon can be used for interconnect and rerouting purposes, for instance to CMA connectors or coax-cable competible connectors. Such connectors cannot be connected to active device directly, as the resolution of the active device is much to high. Wirebonds are not applicable, as it will lead to a substantial loss of signal. Filters and multiplexers can be added on the high-ohmic silicon to desire. The heatsink is necessary for this application, as the mixer produces much heat.

In another application the device of the invention comprises an active device with a substrate of a III-V material, such as InP, in which several semiconductor elements are defined. The active device constitutes in this case an array of optical switches, which allow the provision of signals to a specific output. The switches operate with electrical signals. They are nevertheless known as optical switches in the sense that they form part of an optical network, e.g. a network with optical fibres. The device further comprises photodiodes and/or laserdiodes to convert between the optical transmission and the electrical transmission. The interconnect structure herein mainly fulfills the function of interconnecting between different active devices, each present in its own technology.

In a further application outside the RF domain, the active device is a power amplifier, and the interconnect structure is used to enable feedback loops, and optionally transformers. The device of the invention can be suitably used for this application in view of the heat sink. This heat sink not only is a solution for the requirement of a maximum temperature, but also for the requirement of having a uniform temperature throughout the amplifier, particularly at the different stages thereof. A further advantage is the possibility of integration the required passive components, that are currently provided as discrete components.

In another application, the active device is an array of light emitting diodes. Such array must be addressed with desired circuitry. Furthermore, there is considerable heat dissipation during operation. The device of the invention is very well suitable to provide the needed addressing circuitry and the heat sink in a cost effective manner. Any active part needed for the addressing can be realized both in the substrate and in further active devices assembled in or on the substrate.

The invention further relates to methods of manufacturing such a device.

In a first alternative, the cavity is provided from the first side of the substrate. In the second alternative, the cavity is provided from the second side of the substrate. The method of the first alternative is partially known from US4,199,777. Herein an active device is placed in a cavity in a substrate of glass or ceramic. It is thereafter covered with an insulating film, which also fills up the cavity. Then the insulating film is etched so as to create windows through which connections to the active device can be made.

It is a disadvantage of the known method that the devices show degradation of performance when in use.

It is therefore an object of the invention to provide a method with which better devices can be obtained. This is achieved in that the method comprises the steps of:
- providing a substrate with a first and a second opposed side;
- forming a first cavity starting from the first side of the substrate;
- placing an active device in the first cavity, thereby defining a gap between the active device and the substrate;
- filling the gap between the active device and the substrate,
- planarizing the first side of the substrate by applying a planarization layer,
- defining an interconnect structure at the first side of the substrate interconnecting the active device with any further element present in or at the first side of the substrate and comprising at least one transmission line,
- providing a support layer onto the interconnect structure,
- thinning the substrate from the second side at least to the extent that the first cavity is brought to the surface, and
- providing a heat sink at the second side of the substrate extending over the first cavity and at least part of the substrate.

In the method of the invention, the heat sink is provided in direct contact with the active device by thinning the substrate. It is preferred that the substrate of the active device is thinned as well. In order to maintain the required stability, a support layer is provided on top of the interconnect structure. The gap is filled with a material providing a good adhesion of the electronic element to the walls of the first cavity. For example, this may be done by placing a small droplet of the material, which material may then be spread in the gap by capillary action. Suitable materials for filling the gap are e.g. benzocyclobutenes (BCB) and polyimides, as they provide good adhesion properties. BCB is particularly preferred in view of its stability to a high temperature (350 °C) and its low RF losses. The planarization layer has generally a thickness of 5 - 10 µm. The support layer may be removed afterwards, but that is not necessary, if means for external coupling are provided either at the side of the heat sink, or through the support layer, or the external coupling is contactless. In order to use the heat sink as a ground plane as well, vertical interconnects may be provided through the substrate. Such interconnects are manufactured in that trenches are defined in the substrate, which after the thinning extend to the second side thereof, and are subsequently filled with electrically conductive material. The filling with conductive material is preferably done in the same step as the provision of the heat sink. This may well be done electrochemically, e.g. by electroplating, in which the interconnects structure can act as the plating base. The definition of the trenches can be done in the same step or in a separate step as the provision of the cavities.

This object is further achieved in a method comprising the steps of:
- providing a substrate with a first and a second opposed side;
- defining an interconnect structure at the first side of the substrate and comprising a transmission line and connection faces for electrically coupling any devices or elements in the substrate to the interconnection structure;
- providing a support layer on top of the interconnect structure
- forming a first cavity starting from the second side of the substrate and extending to the interconnect structure;
- placing an active device having a contacting surface provided with connection pads in the first cavity, the connection pads being opposed to the corresponding connection faces in the interconnect structure, the connection pads and the corresponding connection faces being electrically coupled; and
- providing a heat sink at the second side of the substrate extending over the first cavity and at least part of the substrate.

In this method, the cavities are provided from the second side of the substrate. This has a number of advantages. First of all, the interconnect structure can be completed before any cavities are made and any devices are assembled. This allows to separate the manufacturing of the device into steps effected in a semiconductor manufacturing factory and steps effected in an assembly factory thereafter. In fact, after the provision of a mask so as to define the cavities no lithographic step is necessary, but for the patterning of the heat sink. That pattern is however generally on a larger scale, and it may be provided in alternative manners than with photolithography. Secondly, this method allows much more easily to use active devices having various thicknesses. In the prior art method, different thicknesses of different active devices to be provided in one or more cavities can only be leveled out by any planarization layer without negative impact, if the difference is not too large.

A further advantage is that the heatsink may be used to fill up the cavities as well, therewith providing an optimal cooling environment for the active devices. Besides, the heat sink will act as a Faraday cage, with the advantage that electromagnetic coupling to any surroundings is suppressed. Alternatively, a filler material may be used to fill up the cavities. This can be suitable for compensation of differences in thermal expansion coefficients or for absorption of mechanical stresses.

The adhesion means used in order to provide the connection between connection faces and the connection pads may be any of those used conventionally, including metal bumps, solder bumps, glass frit, anisotropically conducting glue. It is preferred that after the positioning the substrate is heated to a temperature above the melting temperature of the heating means, so as to create a good electrical connection. An underfill can be used, if necessary, to stabilize the mechanical connection between active device and the interconnect structure. Instead of providing such an underfill after that the device have been placed, a layer may be used that will soften on heating. Such a layer, for instance an acrylate, is described in the non-prepublished application EP 02077228.1 (PHNL020471), herein included by reference.

Alternatively, use can be made of an adhesive at the surface of the active devices. The electrical connection is then provided in an additional step after that the support layer (which is then removable) is removed. A preferred adhesive is benzocyclobutene, since it has good adhesion properties and a low RF loss. In a heat treatment after the placement of the active devices, to about 190-220 °C, the benzocyclobutene is first softened to become a waterlike fluid, which allows the devices to move. Thereafter, at higher temperatures, the material is cured into a hard adhesive layer.

The support layer in these methods is for instance a layer of glass, which is attached to the interconnect structure with an adhesive. On irradiating with UV radiation, the support layer can be released from the interconnect structure. It is the advantage hereof, that the support layer can be as thick as desired, for instance between 1 mm and 1 cm. However, alternatively, a passivation layer can be used as the support layer. Such a passivation layer need not to be removed afterwards. Instead it can be etched thereafter so as to open the bond pads for external contacting. Alternatively, the opening of the bond pads may be effected before the thinning of the substrate.

It is preferred that the substrate is thinned to a thickness less than the thickness of one or more active devices. This has the advantage that when thinning the active devices, only those are thinned. If in one step both the substrate and the active device are thinned, mechanical tensions and vibrations may come into existence, or even the mechanical connection between the active device and the interconnect structure may be endangered.

The provision of cavities can be effected by the provision of an etch mask and subsequent etching. Both dry etching and wet etching techniques can be used. Particularly suitable for the second method in which the cavities are provision from the second side is wet etching of silicon with KOH, or with TMAH (tetramethylammoniumhydroxide). This may give tapered edges enabling an easier fit and placement of the active devices. Besides, the etch will stop at the interface between the silicon and the silicon oxide layer. This leaves a clean flat surface, which is important for the adhesion of the active devices. In case of dry etching, which is preferred if the cavity are made from the first side of the substrate, the Bosch process is used preferably. The Bosch process is e.g. described in US-A-5 501 893 of F. Laermer and A. Schilp, which is hereby incorporated by reference. Using the Bosch process, the first cavity or cavities in the substrate will have very good side wall slopes.

The connection faces in the interconnect structure are generally provided in that the connection faces are provided in windows in the insulating layer (e.g. for instance SiO2) at the interface with the substrate. These connection faces are provided with a surface layer of a material to which the adhesion means adhere well. Use can be made of Ni/Au that may be deposited electroless. However, alternatives will be apparent to the skilled person in the art of metal and solder bumping.

The provision of the heat sink is advantageously achieved with electroplating. Thereto, a seed layer of a suitable material is provided, and a resist mask is used to define the desired pattern. Then the heat sink is provided by electroplating. The seed layer improves the adhesion between the substrate and the electronically conducting material to be applied in step. The seed layer may comprise for example copper, silver, nickel, chromium, Cr/Cu, Ti/Cu etc. Preferably the seed layer will comprise the same material as the electronically conducting material to be used as heat sink. Preferably the seed layer has a thickness of 50 - 500 nm, more preferably 100 - 200 nm. As a plating mask, e.g. a 5 µm thick layer of AZ4533 resist may be used.

The preferably releasable support ensures the mechanical stability of the substrate. This allows that the thinning of the substrate is done in a relatively aggressive manner. The releasable support may be removed after applying the layer of an electronically conducting material in step (v). The releasable support is preferably planar. For example, the connection between the releasable support and the first side of the substrate can be achieved in a known manner using an UV releasable foil. As the releasable support is removed later on in the method of the present invention, it functions as a temporary or provisional support. The releasable support may be made from e.g. glass, metal, plastics, etc. The temporary, releasable support may be removed e.g. thermally and/or chemically by dissolving or modifying any adhesive or additional layer used. A suitable technique for removing the releasable support is using laser ablation (see e.g. Narayan et al., IEEE trans. on components, packaging and manufacturing technology, Part B, Vol. 18, no. 1, February 1995, pp. 42-46.

These and other aspects of the invention will be further elucidated with reference to the figs., in which:
Figs. 1 - 8 show schematic cross-sectional views of different stages of the first method according to the present invention;
Fig. 9 shows a SEM microphotograph of a semiconductor device obtainable in Fig. 7; and
Fig. 10 - 22 show diagrammatical cross-sectional views of further stages of the first method according to the present invention;
Fig. 23 shows a diagrammatical cross-sectional view of the resulting device;
Fig. 24-30 show diagrammatical cross-sectional views of different stages of the second method according to the invention;
Fig. 31 shows a diagrammatical cross-sectional view of the resulting device;
Figs. 32 and 33 show diagrammatical cross-sectional views of further embodiments of the device;
Fig. 34 shows a detailed cross-sectional view of a part of Fig. 33;
Fig. 35 shows a graph showing the transmissions of coupling made with bond wires, metal balls and thin film interconnects.

### Description of preferred embodiments

Identical reference numbers indicate similar structural components.

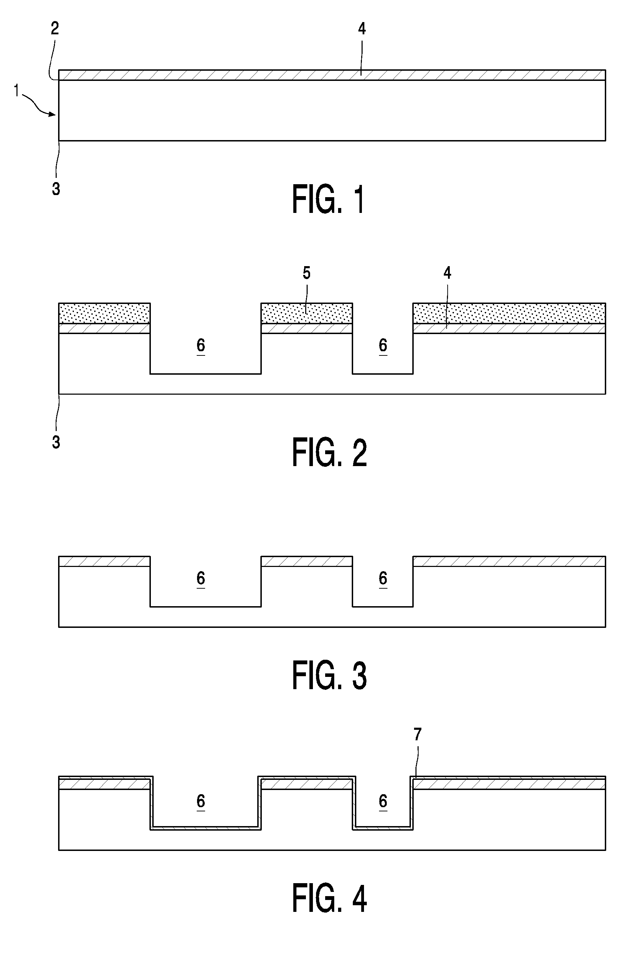

Figs. 1 - 8 show schematic cross-sectional views of different stages of the method according to the present invention.

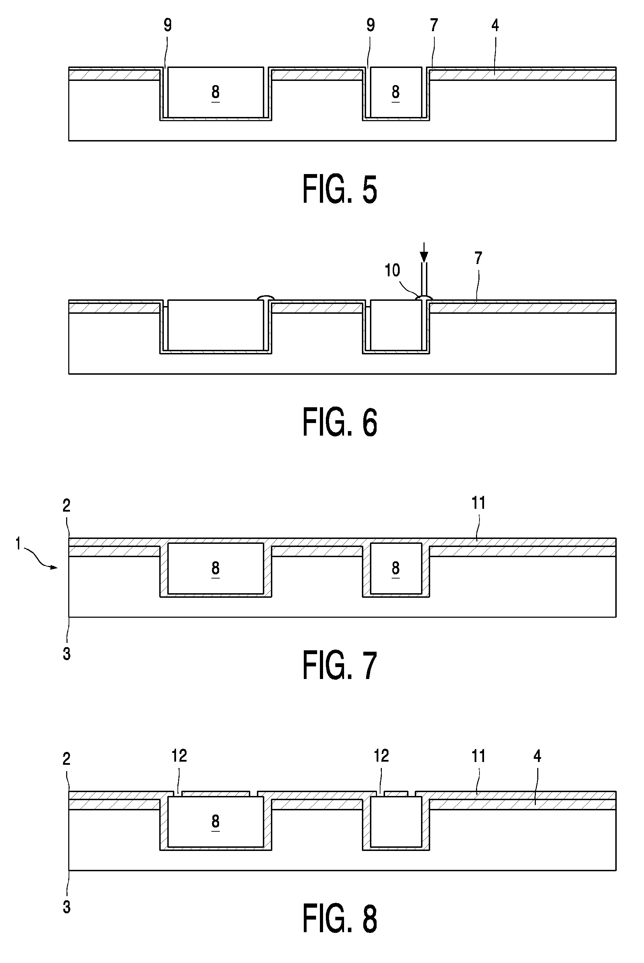

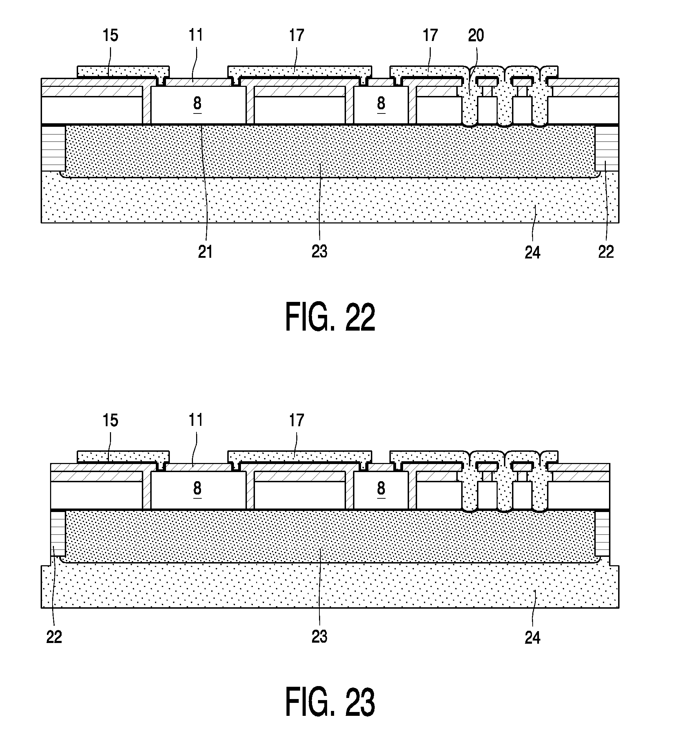

Fig. 1 shows a 700 µm thick silicon substrate 1, having a first side 2 and an opposed second side 3. The substrate 1 is on its first side 2 provided with a thermal oxide layer 4, e.g. 1 µm thick. If a passive substrate is to be obtained (cf. Fig. 8), then the substrate 1 preferably comprises a high resistivity (preferably greater than 2000 ohm.cm) substrate. However, if eventually an active substrate is to be obtained (see Fig. 23), the resistivity of the substrate 1 will depend on the active semiconductor to be obtained eventually, the resistivity of the substrate usually ranging from 20 ohm.cm for bipolar semiconductors to 20 mohm.cm for CMOS semiconductors. In the latter case, the substrate 1 may comprise fully processed IC wafers.

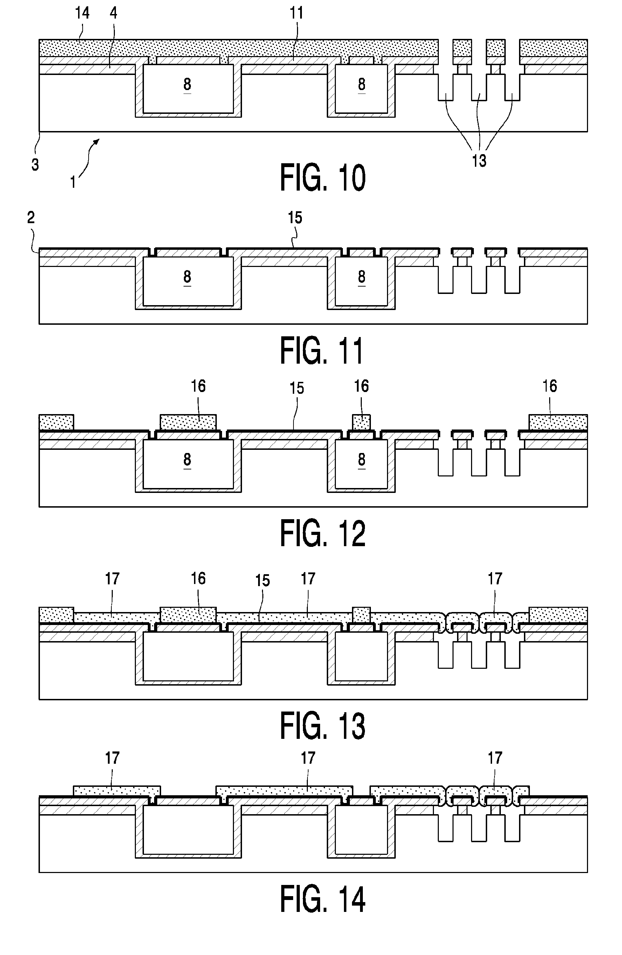

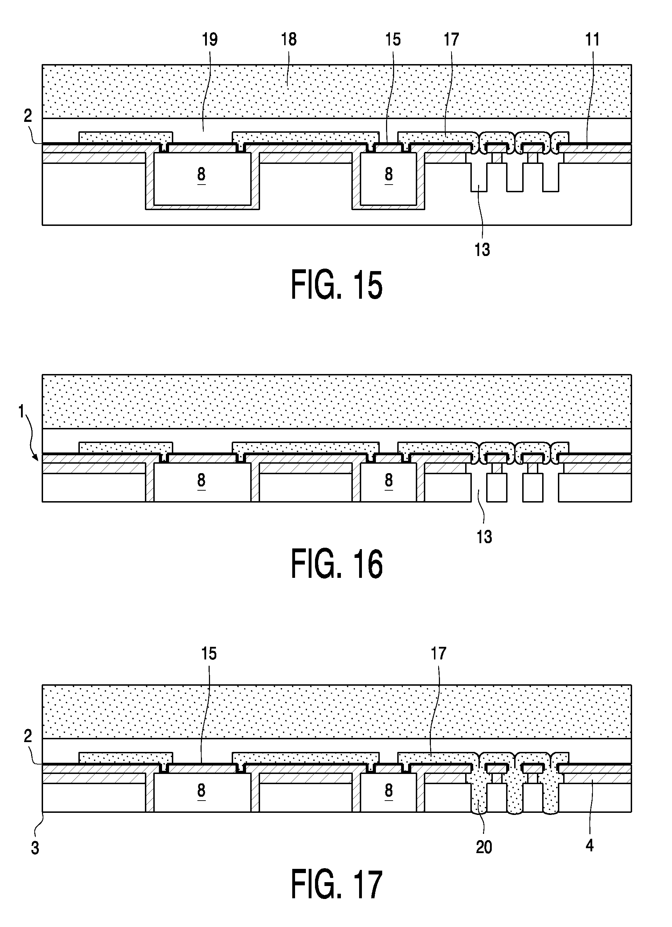

On the first side 2 of the substrate 1 shown in Fig. 1 a layer of a patternable material 5, such as a 10 µm thick resist mask, is applied. The patternable material 5 is then patterned leaving a pattern of the patternable material on the first side 2 of the substrate. Then, first cavity or cavities 6 are formed in the first side 2 of the substrate 1 by removing a part of the substrate 1 being not provided with the layer of patternable material 5, e.g. by etching (see Fig. 2). The person skilled in the art will readily understand that the first cavity 6 may also be formed into a via (see second cavities 13 in Figs. 10 and 16), if desired. Further the cavities 6 may have the same or different depths (which are usually obtained in different steps). Preferably, the first cavities 6 are formed using the Bosch process, as the first cavities 6 will then have very good side wall slopes.

In Fig. 3 the patternable material 5 has been removed from the first side 2 of the substrate 1, e.g. in a thermal or chemical way.

As shown in Fig. 4, the first side 2 of the substrate 3 is coated with a layer 7 of benzocyclobutene (BCB) to allow the electronic element 8 (shown in Fig. 5) to be adhered to the first side 2 of the substrate 1. The electronic elements 8 may be an IC, die, etc. which may be placed in the first cavities 6 by using standard "pick and place" techniques. The first cavity 6 in the substrate 1 and the electronic element 8 define together a gap 9, the gap 9 surrounding the electronic element 8.

As shown in Fig. 6 the gaps 9 are filled with a material 10, preferably BCB. In the shown embodiment this is done by placing a small droplet of the material 10 just above the gap 9, which material 10 may then be spread over the gap 9 by capillary action.

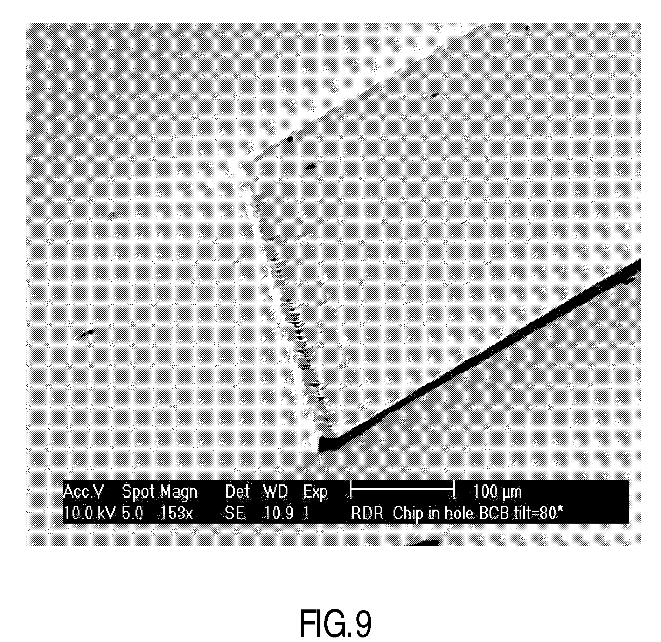

Then, the first side 2 of the substrate is planarized by applying a layer 11 of e.g. BCB or a polyamide on the first side 2 of the substrate 1. If BCB is used for both filling the gap between the electronic element 8 and the walls of the first cavity 6, the electronic element 8 is then enclosed in BCB (see Fig. 7). Typically the layer 11 has a thickness of 5 - 10 µm. As is shown in the SEM microphotograph of Fig. 9, a remarkable planar first side 2 may be obtained with the method according the present invention.

Finally, contacts 12 are defined (see Fig. 8) by removing a part of the layer 11 at selected positions on the first side 2 of the substrate 1. For example, this may be done by etching.

The passive semiconductor device or intermediate product obtained in Fig. 8 may be further processed or interconnected to other semiconductor devices.

Fig. 9 shows a SEM microphotograph of a cavityed IC after planarization of the first side 2 with the layer 11 (cf. Fig. 7). Note the remarkable planar surface of the first side 2.

Figs. 10 - 23 show schematic cross-sectional views of different stages of the method according to the present invention.

The method of the present invention may be continued on basis of the semiconductor device obtained in Fig. 8, or on basis of a ready-made (intermediate) semiconductor device.

The semiconductor device obtained in Fig. 8 is further processed. If desired, second cavities 13 are formed in the substrate 1 in order to allow vias to be formed after thinning of the substrate 1 (see Fig. 16). However, these second cavities 13 may have already been formed at the same time as the first cavities 6 in Fig. 2.

The second cavities may e.g. be formed by applying a layer 14 of a patternable material on the first side 2 of the substrate 1 obtained in Fig. 8; then patterning the layer 14 leaving a pattern of the patternable material on the first side 2 of the substrate 1; and forming second cavities 13 in the first side 2 of the substrate by removing a part of the substrate 1 being not provided with the layer 14. The result is shown in Fig. 10.

Subsequently, the patterned layer 14 is removed from the first side 2 of the substrate 1. Then a seed layer 15 of an electronically conducting material (e.g. copper, Cr/Cu, Ti/Cu, etc.) is applied on the first side 2 of the substrate 1 (see Fig. 11), thereby at least covering the contacts 12 obtained in Fig. 8.

As shown in Fig. 12 a plating mask 16 is then applied on the first side of the seed layer 15. Thereafter, a layer 17 of an electronically conducting material (e.g. copper) is applied on the top face of the seed layer 15, thereby at least partially filling up the plating mask 16 (see Fig. 13). Then, the plating mask 16 is removed from the first side 2 of the substrate 1 (Fig. 14).

As a further step the substrate 1 is thinned thereby exposing the bottom face of the electronic elements 8 and opening the second cavities 13 to the second side 3 of the substrate 1 (see Fig 16.).

However, previously, as shown in Fig. 15, the first side 2 of the substrate may have been provided with a releasable support 18 to improve mechanical stability of the substrate 1. The support 18 may be connected to the substrate 1 using a layer of an adhesive 19. The person skilled in the art will readily understand that the support 18, which may e.g. comprise metal, glass, plastics, etc., may also be provided using any other suitable means. For example the support 18 may be an UV releasable foil. The bottom face of the support 18 being connected to the first side 2 of the substrate 1 is preferably as planar as possible.

In Fig. 16 the result of the thinning of the substrate 1 is shown. The substrate 1 may be thinned by e.g. grinding to a thickness of less than 100 µm. If desired the substrate 1 may be thinned to a thickness of less than 20 µm.

As shown in Fig. 17 the second cavities 13 opened in Fig. 16 are filled with an electronically conducting material 20 (e.g. copper). The material 20 may be filled in the second cavities 13 by electroplating, while using the layer 17 as a plating base.

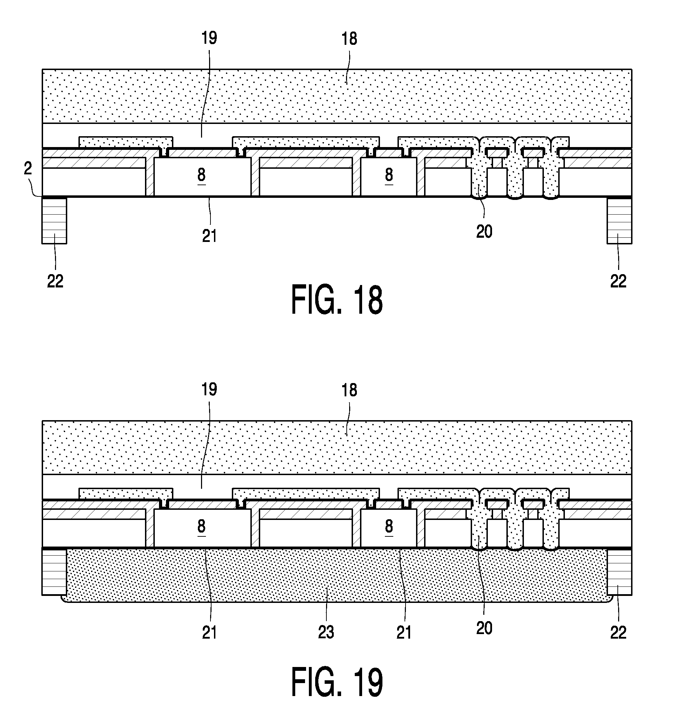

Then seed layer 21 of an electronically conducting material (e.g. copper) is applied on the second side 3 of the substrate 1 obtained in Fig. 17. Subsequently, a saw lane pattern 22 (e.g. from SU8 resist) is applied on the seed layer 21 (see Fig. 18).

As shown in Fig. 19 then a layer of an electronically conducting material 23 (e.g. copper) is then applied on the second side of the seed layer 21, preferably by electroplating, thereby at least partially filling up the saw lane pattern 22.

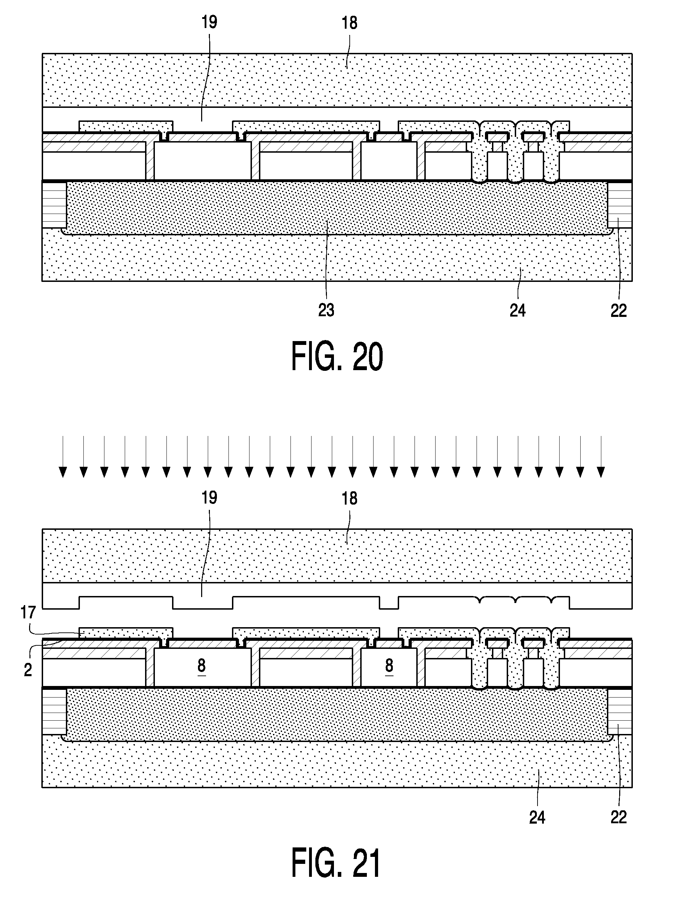

In Fig. 20 the substrate 1 is mounted on a standard separation foil 24. Thereafter, as shown in Fig. 21, the releasable support 18 and adhesive 19 are removed.

Then, that part of the seed layer 15 that is exposed after removing the plating mask 16 from the first side 2 of the substrate 1 in Fig. 14 is removed (see Fig 22).

Finally, the semiconductor devices are separated by separating at the saw lane 22, e.g. by sawing. An active semiconductor device as shown in Fig. 23 is then obtained.

Next, the individual devices may be further processed, e.g. soldered into or onto a package and subsequently connected (e.g. using wire bonding, flip chip and other conventional packaging techniques, etc.).

The semiconductors according to the present invention are extremely suitable for use at frequencies above 10 and even 20 GHz.

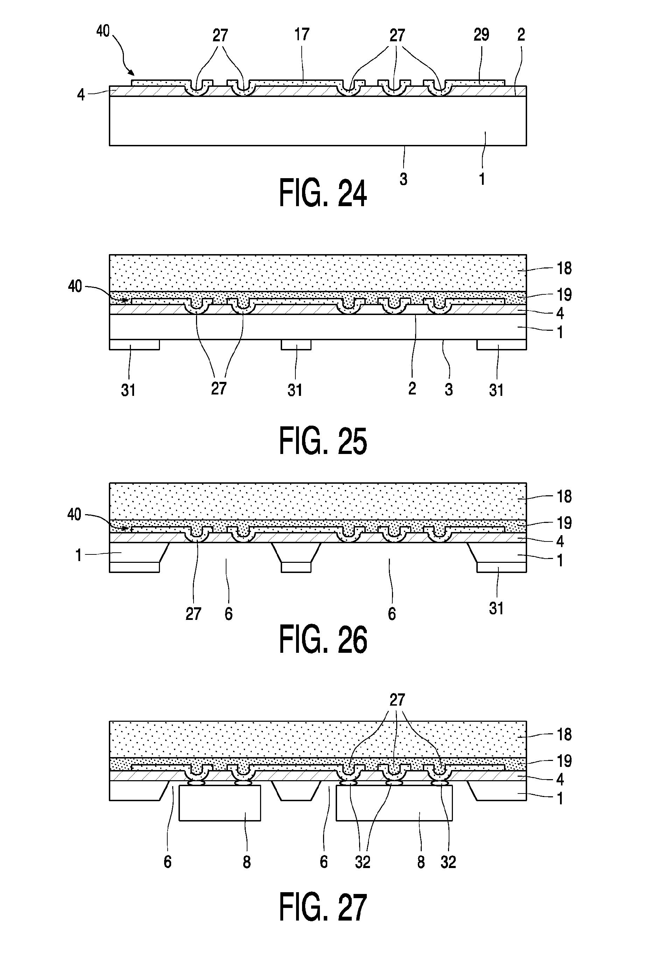

Fig. 24-Fig. 31 shows schematically different stages of the second method resulting in the device of the invention. This second method differs from the first method, in that the active devices 8 are not provided in cavities 6 extending from the first side 2, but in cavities from the second side 3.

Fig. 24 is a diagrammatical cross-sectional view of a first stage in this method. Basically, it shows a fully processed wafer of a semiconductor material, in this case silicon, on top of which an interconnect structure 40 is provided. The interconnect structure 40 comprises transmission lines 17 and vertical interconnects 27 extending to the first side of the semiconductor substrate 1 and through the thermal oxide layer 4. Contrarily to conventional processing, there are vertical interconnects 27, that are not connected to underlying semiconductor elements. The interconnect structure further comprises bond pads 29 for external connection. These bond pads could be used for wirebonding. However, for a good high frequency behavior the use of solder balls is preferred. It is even more preferred that all high-frequency functions will be integrated on and in the substrate 1. In that case the connection are needed only for power and relatively low-frequency input and output signals. A flex foil can then therefore be used. For reasons of clarity a one-layer interconnect structure 40 is shown. However, in practice a multilayer interconnect structure is preferred.

Fig. 25 shows the substrate 1 in a second stage of the processing. First of all, the substrate 1 as shown in Fig. 24 is provided with a mechanical support 18 on its first side 1. In this case, a glass support wafer 18 is used which is attached to the substrate 1 using UV releasable glue 19. Thereafter, the substrate 1 is thinned from its second side. These steps are identical to the steps shown in Fig. 15 and 16. Finally, a suitable etch mask 31 is deposited and patterned. In this case an etch mask of aluminum is used, that has been provided by chemical vapor deposition and that has been patterned photolithographically. Such an etch mask 31 may also be provided in different manners, for instance with any kind of printing, with sputtering through a mask and the like.

Fig. 26 shows the substrate 1 in a third stage, after the substrate has been etched through the etch mask 31 The etch mask 31 is suitable for dry etching, but also for wet etching with for instance potassium hydroxide or tetramethylammonium hydroxide. The result of this wet etching are cavities 6 with side walls that enclose an angle of 45° with respect to the plane of the substrate 1. These tapered side walls have the advantage that placement of active devices gets easier as the fit in the cavity is less tight.

This second method of the invention has the advantage that the substrate 1 at the second or at the third stage as shown in Fig. 25 and Fig. 26 can be transferred to an assembly factory for further processing. This further processing is done at a larger scale and involves standard steps as die placement, electroplating and separation.

Fig. 27 shows the substrate 1 in a fourth stage, after placement of active devices 8. In order to ensure good contact, it is preferable that the vertical interconnects 27 which have appeared at the surface in the cavity 6 are provided with metal contacts, particularly of Au, through electroless deposition of Ni/Au. The active devices 8 are provided with solder or metal bumps 32. After the placement, an underfill is provided and a heat treatment is done so as to provide a metallic contact between the bumps 32 and the vertical interconnects 27. Instead of an underfill, use can be made of a liquifying layer which is provided in the cavity 6 before placement of the active devices 8. A good example of such liquifying layer is an acrylate layer, that will liquify under heating to about 60-100 °C. Another example is benzocyclobutene (BCB), which becomes a waterlike fluid at about 170°C. When the temperature is brought above 200 °C, the BCB cures into a hard adhesive layer. A further alternative to the underfill is the provision of a glue layer at the surfaces of the active devices. The glue layer is preferably patterned, so as to enable the provision of bumps 32. A preferred glue layer is BCB.

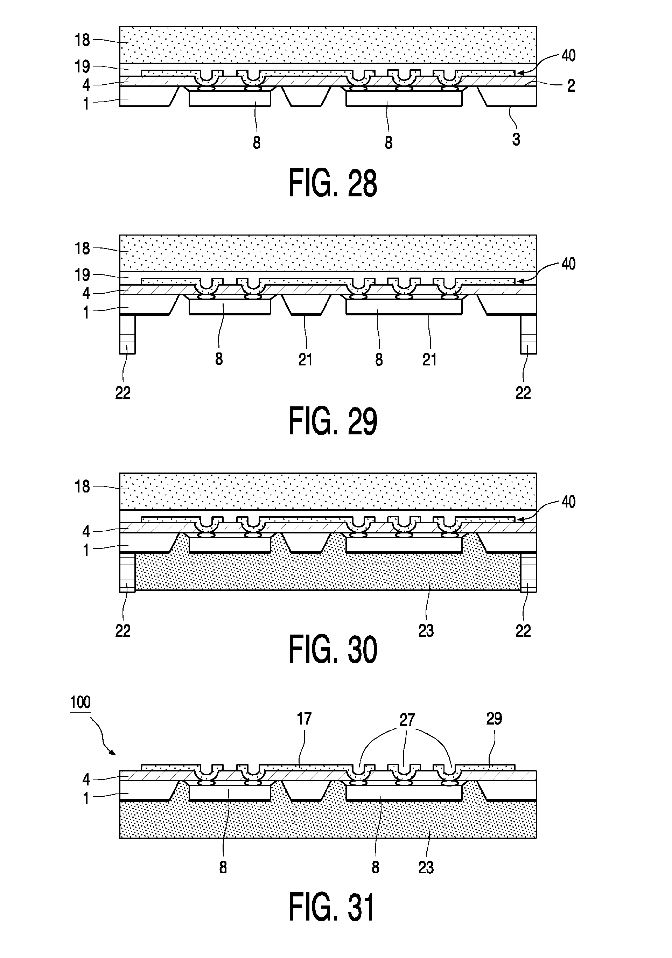

Fig. 28 shows the substrate 1 in a fifth stage, after provision of the underfill and after planarization of the rear sides of the active devices 8 and the second side 3 of the substrate 1.

The device 100 is now ready, but for the cavities 6 to be filled and the heatsink 23 to be applied. In this embodiment, the heatsink 23 fills the cavities 6, and it covers substantially the complete second side 3 of the substrate 1. It is however not necessary to fill the cavities with the heatsink. The cavities may be filled with a material having a thermal expansion coefficient that matches with the thermal expansion of the active devices 8. Alternatively, an elastic material may be chosen so that mechanical stress between the active devices 8 and the substrate 1 is absorbed.

Fig. 29 shows the substrate 1 after a plating base 21 has been applied to the second side 3 of the substrate 1, and after a resist 22 has been provided and patterned at areas at which no heatsink is desired. A suitable plating base is Cr/Cu. A suitable resist is SU8.

Fig. 30 shows the substrate 1 after that the heatsink 23 of copper has been grown by electroplating. The advantage of the electroplated copper is that it has a low stress. An advantage of the filling of the cavities 6 with the copper is that the active devices 8 get surrounded by metal. This metal acts as a Faraday cage, therewith suppressing electromagnetic coupling to the surroundings. The heat sink 23 may have a thickness of more than 100 µm. Therewith mechanical stability is optimized. This is however not necessary, particularly not, if the device is attached to a leadframe and encapsulated in a protecting mould.

Fig. 31 shows the device 100 after removal of the support wafer 18 and the separation. It will be understood that there may be provided vertical interconnects between the interconnect structure and the heat sink, such as shown in Fig. 19. Although the fig. provides the suggestion that the substrate 1 is removed to a large extent, this need not to be and is generally not the case.

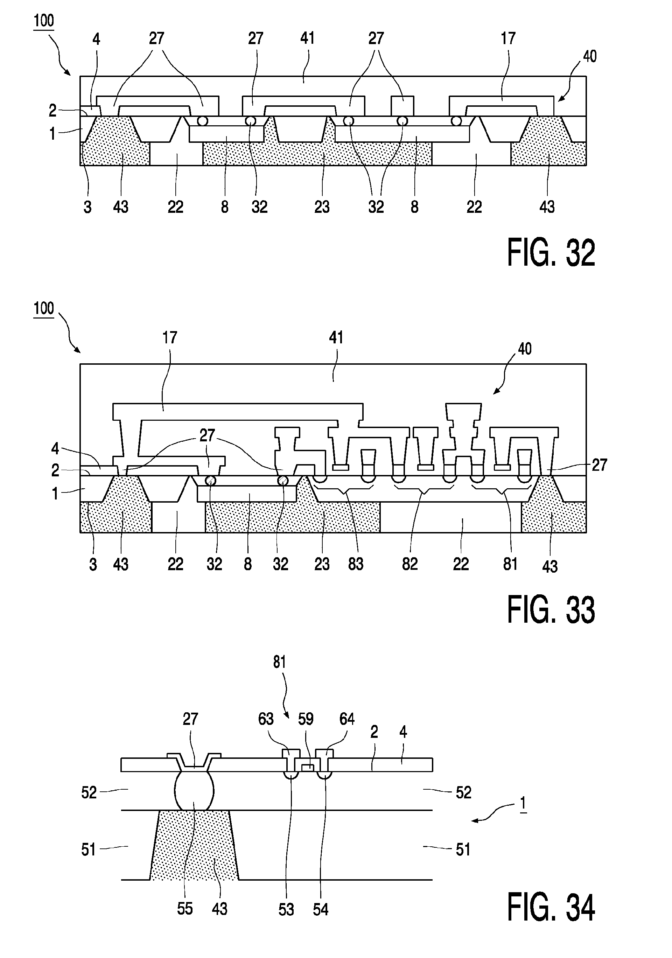

Fig. 32 shows a diagrammatical cross-sectional view of a another embodiment of the device 100 of the invention. In this embodiment, the heat sink does not extend over the second side 3 of the substrate 1 completely. Instead thereof, contacts 43 are provided in addition to the heatsink 23, therewith enabling the placement of the device 100 on a carrier without the need for a leadframe. Nevertheless, the pattern of the contacts 43 and the heatsink 23 is at least largely identical to that of conventional leadframes, as for instance the HVQFN (high voltage quad flat non-leaded) leadframe. In order to realize such, the heatsink 23 may cover only partially the active devices 8, as is shown in the fig.. In a further not-shown embodiment, the heatsink could be applied in two steps, the first layer of the heatsink having a different pattern than the second heatsink. This can be called "rerouting" of the heatsink.

In this embodiment, the first side 2 of the substrate 1 is provided with an encapsulating layer 41. This material is for instance a filled epoxy or a polyimide, as known to the skilled person. This encapsulating layer 41 can be provided on wafer level, e.g. before separation of the device. It may have any desired thickness, for instance in the order of 0.1-100 µm, and is chosen such, that it can be cut easily with conventional sawing apparatus. The encapsulating layer may be provided before the attachment of the support wafer, or after the removal of the support wafer. In principle, it could be used instead of the support wafer. Then however, it is preferred that it has sufficient thickness. Preferably, it is then provided as a multilayer stack. This stack could for instance include a security coating that is not transparent and cannot or hardly be removed so as to prevent reverse engineering of the underlying circuit.

Fig. 33 shows a further embodiment of the device 100 of the invention. In this embodiment, the substrate 1 comprises active elements, in this case field effect transistors 81, 82, 83 having source-electrode, drain electrode and gate electrode. The interconnect structure 40 includes in this embodiment not only the interconnects between the active devices 8 and other elements, but also the interconnects between the individual transistors 81,82,83, within the integrated circuit itself. In this case the interconnect structure 40 further includes vertical interconnects 27 extending to contacts 43 at the second side 3 of the substrate 1.

Although not shown here, it is preferred that the connection between the contacts 43 and the interconnect structure is made at the third or higher level of the interconnect structure only. In order to realize this, the interconnect structure is partitioned in an area for the integrated circuit and an area for the active device 8. These areas are mutually insulated by insulating material at the non-interconnected lower levels, so that the signal to the active device 8 does not affect the signal of the individual transistors 81,82,83.

Fig. 34 shows a detail of Fig. 33 showing more clearly the connection to the contact 43 which is at the same level as the transistor 81. The connection to the active device 8 is basically the same as that to the contact 43. The semiconductor wafer is herein shown to have various doping zones 51, 52,53,54,55. The main part 51 of the substrate 1, that is partially removed, is a p⁺-zone. The transistor 81 is formed in and on an p-type epilayer 52. The source- and drain-electrodes 53, 54 are highly doped zones at the surface of this epilayer 52. Finally, there is a highly doped n⁺⁺-zone 55 acting as an interconnect. The transistor is further provided with a gate electrode 59, that is separated from the epilayer 52 through a non-shown thin gate oxide. The substrate 1 is provided with a thermal oxide 4 at its first side 2. This thermal oxide 4 is patterned and vertical interconnect 27, as well as contacts 63,64 to the source, drain and gate electrode are provided (the contact to the gate is not shown).

It is understood that a metal connection that is suitably insulated from the semiconductor substrate may be used instead of the highly doped zone in the silicon itself. The undesired interaction between vertical interconnects and transistors can be prevented through the use of adequate design rules, such as for instance a minimal distance of 5 to 10 µm. The resulting effect is negligible in view thereof that the epilayer 52 generally has a very limited thickness only.

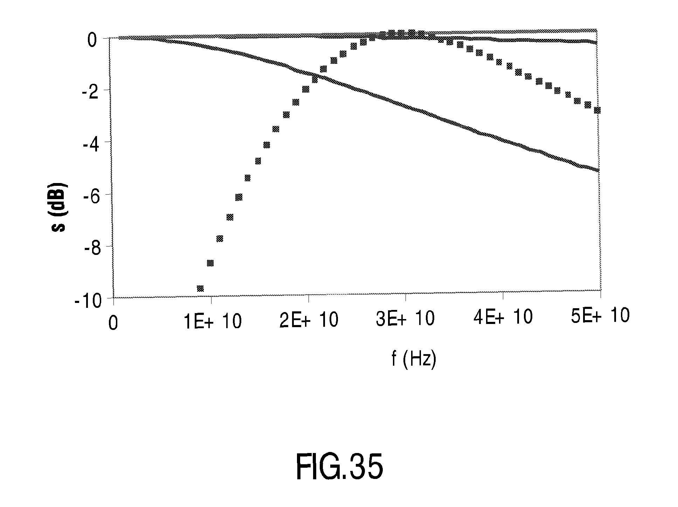

Fig. 35 shows a graph in which the transmission as a function of the frequency is compared for various coupling techniques. The continuous lines show from the bottom to the top the transmission of a bond wire, of a metal or solder ball and of an thin-film interconnect. The dotted line shows a bond wire compensated with a capacity at 30 GHz. The graph is the result of a simulation done for the transfer of a source of 50 Ω to another source of 50 Ω. The result of the use of bond wires without compensation is a transmission of -3 dB at 30 GHz. This corresponds to a reduction of the signal intensity with 50 %. The compensated bond wires provides a better result at those frequencies, but has the disadvantage that only for exactly 30 GHz the transmission is unaffected. At about 25 GHz the transmission is only -1dB. This is already problematic, in view of the large number of signals to be processed and particularly in view thereof, that the signal are preferably kept small at these frequencies so as to reduce heat dissipation.

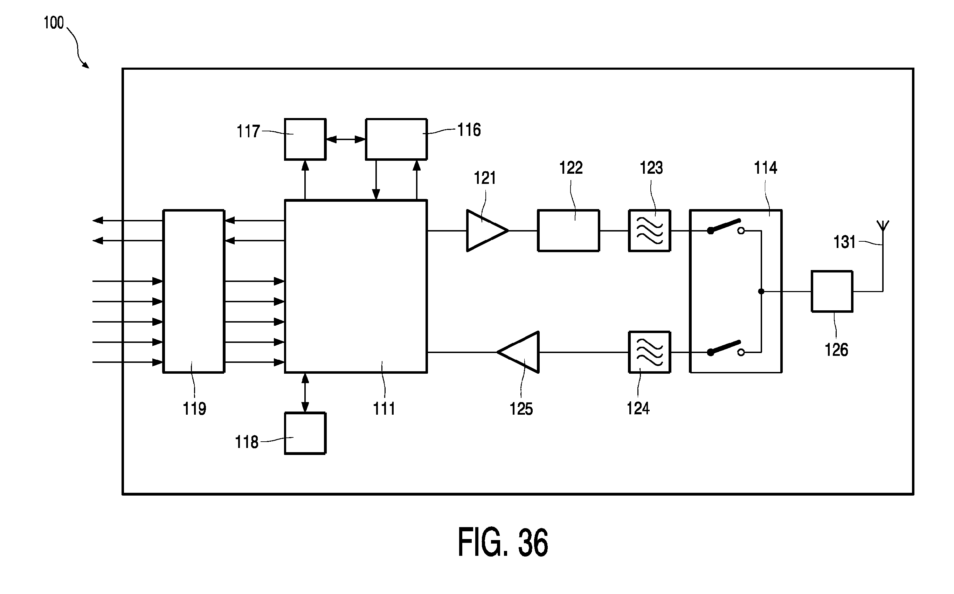

Fig. 36 shows a block diagram of an electronic device according to the invention which contains only low-frequency input signals. The device 100 comprises a transceiver 111, which is provided with six inputs. These input signals and the corresponding output signals are converted through a multiplexer and demultiplexer unit 119. Coupled to the transceiver are a VCO tank 116, a PLL loop filter 117 and a supply decoupling unit 118. The transceiver 111 is capable of sending signals to the antenna 131 and receiving signals from the antenna 131. A TX/RX switch 114 is present for switching from the receiver to the transmitter function and vice versa. The transmit path between the transceiver 111 and the switch 114 comprises a power amplifier 121 and an impedance matching function 122, as well as a filter 123. The power amplifier 121 generally comprises two or more stages, one of which may be bypassed. The receive path between the switch 114 and the transceiver 111 comprises a filter 124, and a low noise amplifier 125. This low noise amplifier can be integrated in the transceiver 111. A band pass filter 126 is present between the antenna 131 and the switch 114.

Although not shown here for reasons of clarity, the TX/RX switch 114 generally comprises the switching function between different frequency bands, such as the DSC band, the GSM band, the Bluetooth band and any further band. The TX/RX switch comprises furthermore the passive elements and switches needed to prevent that any amplified signal reaches a receive path in which it will blow up the amplifier. However, particularly if high frequencies are present, it is advantageous to use to separate antennas for different frequency ranges. Antennas for high frequencies of 20 GHz can be very small, and the band separation gets easier.

In the present invention, the TX/RX switch 114 and the impedance matching function is realized with MEMS-capacitors and switches, that are provided as part of the interconnect structure. The power amplifier 121 is realized as an active device with a substrate of a III-V material, such as GaAs of GaN. Good results have been obtained in that the active device comprises transistors of the HBT-type. The transceiver 111 is embodied as an active device with a substrate of a III-V material, particularly of InP, that is suitable for frequencies of 10-40 GHz. For the Voltage Controlled Oscillator 116 use is made of an active device of a SiGe substrate. These active devices are all provided in cavities, but the VCO 116 may be embodied in the substrate itself alternatively. The PLL loop filter 115 is subdivided over the interconnect structure and the substrate. The VCO 116 could be assembled to this separate unit alternatively. The band pass filters and other filters can be baluns and LC filters that are integrated in the interconnect structure. At least some of them can be BAW-filters alternatively. These can be suitably provided as separate blocks in cavities in the substrate or with bumps on the interconnect structure. Such passive functions can be provided on top of the substrate with bumps, since they do not need any connection to a heat sink.

The person skilled in the art will understand that many modifications may be made without departing from the scope of the appended claims.

## Claims

1. An electronic device comprising:
- a substrate having a first and a second opposed side, which is provided with a first cavity having an aperture at the first side of the substrate and extending to the second side, the substrate being provided with a first electrical element at its first side;
- an active device having a coupling surface provided with connection pads, which device is present in the first cavity of the substrate with its coupling surface at the first side of the substrate, any space left in the cavity being filled with a filling material;
- a thin film interconnect structure being provided at the first side of the substrate extending over the first cavity and interconnecting the active device with the electrical element, the interconnect structure comprising connection faces corresponding to the connection pads, and
- a heat sink is present at the second side of the substrate extending over the first cavity and at least part of the substrate.

2. An electronic device as claimed in Claim 1, wherein the interconnect structure comprises a first transmission line extending over the first cavity and the substrate

3. An electronic device as claimed in claim 1, wherein a vertical interconnect extends from the interconnect structure through the substrate to the heat sink, which heat sink being able to act as a ground plane.

4. An electronic device as claimed in claim 1, wherein the substrate comprises a semiconductor material.

5. An electronic device as claimed in claim 4, wherein the first electrical element is an active element which is defined in the substrate of semiconductor material.

6. An electronic device as claimed in claim 4, wherein the first electrical element is a passive component defined on the semiconductor material.

7. An electronic device as claimed in claim 1,2 or 3, wherein the active device is a semiconductor device having a semiconductor substrate of a compound semiconductor material.

8. A device as claimed in claim 1, comprising:
- multiplexers and demultiplexers enabling a transformation between a low frequency input signal and a high frequency signal of desired frequency with a frequency band that is used for the signal transmission in the device,
- coupling means for transmission of high frequency signals to and/or from an external system;
- means for signal transmission and amplification of the high frequency signal within the frequency band, the active device and the transmission line being part hereof.

9. A device as claimed in claim 8, comprising means for signal transmission and amplification in at least two frequency bands.

10. A device as claimed in claim 1 or 7, wherein the active device is an optoelectronic semiconductor element enabling a transformation of an optical signal into an electric signal.

11. A device as claimed in claim 10, further comprising a second active device that is provided in a cavity and directly coupled to the interconnect structure, and that functions as an amplifier for amplifying the received electrical signal, the device further comprising signal transmission means of which the first transmission line is part.

12. A device as claimed in claim 10, further comprising an antenna and further signal transmission means enabling wireless communication at a desired frequency.

13. A method of manufacturing an electronic device comprising the steps of:
- providing a substrate with a first and a second opposed side provided with a first cavity starting from the first side of the substrate;
- placing an active device in the first cavity, thereby defining a gap between the active device and the substrate;
- filling the gap between the active device and the substrate,
- planarizing the first side of the substrate by applying a planarization layer,
- defining an interconnect structure at the first side of the substrate interconnecting the active device with any further element present in or at the first side of the substrate and including a transmission line;
- providing a support layer onto the interconnect structure,
- thinning the substrate from the second side at least to the extent that the first cavity is brought to the surface, and
- providing a heat sink at the second side of the substrate extending over the first cavity and at least part of the substrate.

14. A method of manufacturing an electronic device comprising the steps of
- providing a substrate with a first and a second opposed side;
- defining an interconnect structure at the first side of the substrate and comprising at least one transmission line and connection faces for electrical coupling of any devices or elements in the substrate to the structure;
- providing a support layer on top of the interconnect structure;
- forming a first cavity starting from the second side of the substrate and extending to the interconnect structure;
- placing an active device having a coupling surface provided with connection pads in the first cavity, the connection pads being opposed to the corresponding connection faces in the interconnect structure, the connection pads and the corresponding connection faces being electrically coupled ; and
- providing a heat sink at the second side of the substrate extending over the first cavity and at least part of the substrate.

15. A method as claimed in claim 14, **characterized in that** the electrical coupling between connection pads and connection faces is realized with balls comprising a suitable metal or alloy, the balls being provided on at least one of the connection pads and the connection faces, and being heated to above the melting temperature of the metal or alloy after the placing of the active device in the cavity in the substrate.

16. An audio and video transmission system comprising the device as claimed in any of the claims 1-12.

17. Use of the electronic device as claimed in any of the claims 1-12 for transmission and amplification of a signal at a frequency of at least 2 GHz.
